# FASCICULE DE BREVET EUROPEEN

(11) **EP 2 774 186 B1**
(45) Date de publication et mention de la délivrance du brevet: **07.02.2018**
(21) Numéro de dépôt: 12794424.7
(22) Date de dépôt: 31.10.2012
(51) Int. Cl.: H01L 31/055, H01L 31/0216

(54) **CELLULE PHOTOVOLTAÏQUE AVEC DIAMANTS FLUORESCENTS**
FOTOVOLTAIKZELLE MIT FLUORESZIERENDEN DIAMANTEN
PHOTOVOLTAIC CELL INCLUDING FLUORESCENT DIAMONDS

(30) Priorité: 03.11.2011 FR 1159971
(43) Date de publication de la demande: 10.09.2014
(73) Titulaire: Association Pour La Recherche Et Le Développement De Méthodes Et Processus Industriels "Armines", 75272 Paris Cedex 06 (FR)
(72) Inventeur: THOREL, Alain, 91770 Saint-Vrain (FR); CURMI, Patrick, 92140 Clamart (FR); BOUDOU, Jean-Paul, 92370 Chaville (FR); JELEZKO, Fedor, 89073 Ulm (DE)
(74) Mandataire: Gilbey, Vincent
(86) Numéro de dépôt international: PCT/FR2012/052531
(87) Numéro de publication internationale: WO 2013/064784

(56) Documents cités:
- WO-A1-2009/099568
- WO-A1-2010/123735
- FR-A1- 2 871 243
- US-A1- 2004 109 328
- LINJUN WANG ET AL: "Efficient luminescence from CVD diamond film-coated porous silicon", JOURNAL OF PHYSICS: CONDENSED MATTER, INSTITUTE OF PHYSICS PUBLISHING, BRISTOL, GB, vol. 12, no. 13, 3 avril 2000 (2000-04-03) , pages L257-L260, XP002313752, ISSN: 0953-8984, DOI: 10.1088/0953-8984/12/13/104

## Description

La présente invention concerne une cellule photovoltaïque comportant à sa surface une première couche qui est apte à générer une tension électrique lorsqu'elle est illuminée et qui est à base d'un matériau dont le spectre de sensibilité lumineuse est maximum entre 600 nm et 1300 nm.

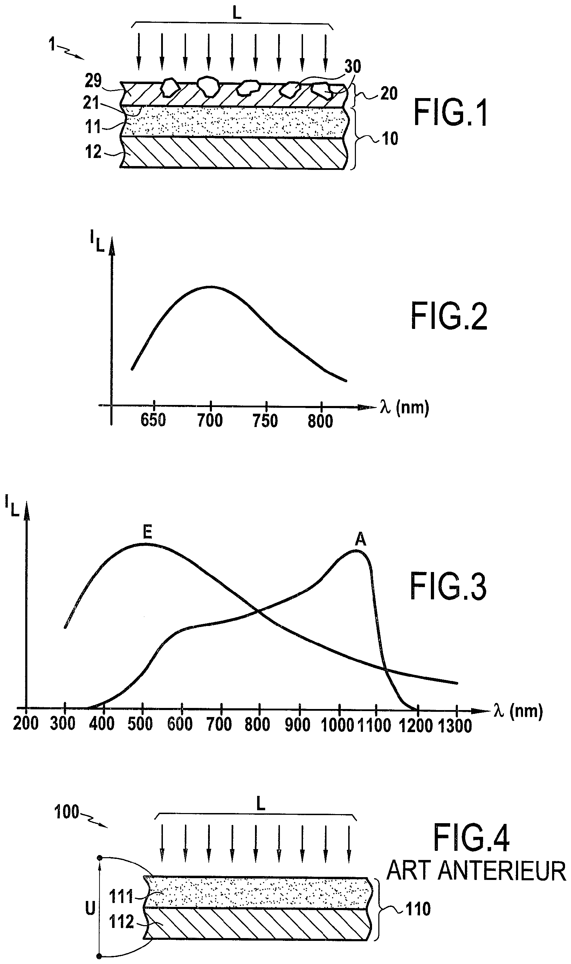

Une cellule photovoltaïque est un composant électronique qui, exposé à la lumière (photons), produit de l'électricité grâce à l'effet photovoltaïque qui est à l'origine du phénomène. On en rappelle brièvement ci-dessous le principe, en référence à la figure 4 qui représente une cellule photovoltaïque 100 classique selon l'art antérieur.

Cette cellule comprend une première couche 110 en silicium qui elle-même comporte une première sous-couche 111 en silicium dopé avec un élément (tel que le Phosphore) qui possède plus d'électrons que le silicium (la quantité d'électrons libres dans cette sous-couche est supérieure à une couche de silicium non-dopé) et une seconde sous-couche 112 en silicium dopé avec un élément (tel que le Bore) qui possède moins d'électrons que le silicium (la quantité d'électrons libres dans cette sous-couche est inférieure à une couche de silicium non-dopé) et donc plus de trous d'électrons. La première sous-couche 111 est ainsi appelée couche de type « N » et la seconde sous-couche 112 est appelée couche de type « P ».

Ces éléments de dopage ne représentent qu'un pourcentage très faible (inférieur à 1%) du matériau de la première couche 110, qui est donc presque exclusivement en silicium.

Lors de la mise en contact de ces deux sous-couches, les électrons libres de première sous-couche 111 rentrent dans la seconde sous-couche 112, et vont se recombiner avec les trous de la seconde sous-couche 112. Il existe ainsi une charge positive de première sous-couche 111 au bord de la première couche 110 (parce que les électrons en sont partis) et une charge négative dans la seconde sous-couche 112 au bord de la première couche 110 (parce que les trous en ont disparu).

Lorsqu'un photon frappe la première sous-couche 111 (qui est exposée à la lumière solaire), un électron d'un atome de silicium est libéré et un ion positif est créé. L'électron se dirige vers la première sous-couche 111 et les trous se dirigent vers la seconde sous-couche 112. Une tension électrique U est ainsi créée aux bornes de la première sous-couche 111 et de la seconde sous-couche 112, tension qui est fonction de la lumière incidente L sur la cellule.

L'intensité I, et donc la puissance électrique W (W=UxI) restituée par la cellule 100 est fonction de la puissance de l'ensoleillement (Watts/(mètres²)), avec un coefficient de rendement.

Les cellules photovoltaïques actuelles, qui sont notamment utilisées dans des panneaux solaires, présentent l'inconvénient que leur coefficient de rendement est faible, au maximum de l'ordre de 20%.

Ceci est notamment dû au fait qu'il existe un décalage entre le spectre d'émission lumineuse par le soleil, et le spectre de sensibilité lumineuse du silicium.

La figure 3 illustre cette situation, avec un diagramme avec en abscisse la longueur d'onde λ de la lumière (en nanomètres = nm) et en ordonnée l'intensité lumineuse I_{L}.

Sur ce diagramme, la courbe E est la courbe du spectre d'émission lumineuse par le soleil. On note un maximum aux couleurs bleues-vertes (450 à 500 nm) et une décroissance au fur et à mesure que l'on progresse dans l'infrarouge (au-dessus de 700 nm) vers des longueurs d'ondes plus élevées.

La courbe A est la courbe du spectre de sensibilité lumineuse du silicium. On note un maximum de cette courbe dans l'infrarouge lointain (au-dessus de 1000 nm) entre 1000 nm et 1100 nm, et une décroissance jusqu'à zéro à la couleur bleue (environ 400 nm) au fur et à mesure que l'on progresse vers des longueurs d'ondes plus faibles.

Le décalage entre la courbe A et la courbe E explique le faible rendement énergétique d'une cellule photovoltaïque.

Une solution pour remédier à ce problème consiste à recouvrir la couche de silicium avec un matériau qui absorbe la lumière solaire puis réémette une lumière de longueur d'onde plus élevée (matériau de photoconversion), de façon à ce que le spectre de lumière irradiant la couche de silicium soit davantage en adéquation avec le spectre de sensibilité lumineuse du silicium. Cependant les matériaux aptes à effectuer une telle translation de spectre, tels que les « quantum dots », phthalocyanine de zinc, et "carbon dots", voir par exemple le document WO 2009/099568 A1, ont un coût élevé qui les rend inutilisables hors du laboratoire. De plus, ces matériaux ne conservent leurs propriétés de photoconversion que sur une durée très inférieure à la durée de vie d'une cellule photovoltaïque classique, qui est de 20 ans Enfin, certains de ces matériaux sont toxiques (par exemple les « quantum dots » Cd-Se), ce qui rend l'élaboration et le recyclage de telles cellules photovoltaïques difficiles.

La présente invention vise à remédier à ces inconvénients.

L'invention vise à proposer une cellule photovoltaïque dont le rendement est supérieur sur toute la durée de vie de la cellule photovoltaïque, et dont le coût soit le plus faible possible.

Ce but est atteint grâce au fait que la cellule photovoltaïque comporte sur la première couche une seconde couche comprenant des diamants fluorescents artificiels comportant en majorité des défauts constitués des couples atome d'azote - lacune, cette seconde couche étant une couche du côté extérieur de la cellule photovoltaïque de telle sorte que des rayons lumineux sont aptes à illuminer les diamants fluorescents.

Grâce à ces dispositions, le rendement énergétique d'une cellule photovoltaïque dont la première couche est à base d'un matériau dont le spectre de sensibilité lumineuse est maximum entre 600 nm et 1300 nm est augmenté, car un diamant fluorescent réémet la lumière solaire qu'il a absorbée dans un spectre lumineux qui est plus proche du spectre de sensibilité lumineuse de ce matériau. Par ailleurs, le diamant présentant un indice de réfraction plus élevé que les autres matériaux, la quantité de photons dirigés vers cette première couche est plus importante, en particulier pour des angles d'incidence des rayons solaires faibles, que si les diamants sont absents ou remplacés par un autre matériau, ce qui augmente encore le rendement énergétique de la cellule photovoltaïque. En outre, l'indice de réfraction élevé confère à la cellule photovoltaïque des propriétés antireflets. De plus, la dureté du diamant, qui est la plus élevée des matériaux connus, confère à la cellule photovoltaïque une excellente résistance à l'usure.

Par ailleurs, les diamants fluorescents présentent un coût beaucoup moins élevé que les matériaux de photoconversion utilisés jusqu'à présent.

Par exemple, cette première couche est à base de silicium. Le diamant fluorescent est artificiel avec une fluorescence augmentée par rapport à la fluorescence d'un diamant naturel.

Ainsi, le rendement de conversion de la lumière solaire en lumière réémise est maximisé, et proche de 1.

L'invention sera bien comprise et ses avantages apparaîtront mieux, à la lecture de la description détaillée qui suit, d'un mode de réalisation représenté à titre d'exemple non limitatif. La description se réfère aux dessins annexés sur lesquels :
- la figure 1 représente une cellule photovoltaïque selon l'invention,
- la figure 2 est un diagramme montrant la courbe d'émission en fluorescence d'un centre NV dans un diamant d'une cellule photovoltaïque selon l'invention,
- la figure 3 est un diagramme montrant le spectre d'émission lumineuse par le soleil et le spectre de sensibilité lumineuse du silicium,
- la figure 4 représente une cellule photovoltaïque selon l'art antérieur.

La figure 1 illustre une cellule photovoltaïque 1 selon l'invention. Cette cellule 1 comporte une première couche 10 en un matériau qui est apte à générer une tension électrique entre sa face inférieure et sa face supérieure, et dont le spectre de sensibilité lumineuse est maximum entre 600 nm et 1300 nm (la première couche comporte en outre des éléments de dopage en quantité inférieure à 1%).

Un tel matériau est par exemple du silicium.

La description ci-dessous est basée sur le cas où cette première couche 10 est en silicium, puisque la majorité des cellules photovoltaïques utilisées est à base de silicium. Cependant d'autres matériaux (tels que des alliages CGIS (alliage de cuivre, indium, gallium, sélénium)) peuvent être utilisés, et l'invention s'applique à toute cellule photovoltaïque dont le matériau de la première couche présente un spectre de sensibilité lumineuse dont le maximum se situe dans une plage allant de 600 nm à 1300 nm. En effet, la lumière solaire incidente est réémise par les diamants fluorescents en une lumière dont le spectre d'intensité est maximum dans cette plage.

La structure de cette première couche 10 est par exemple identique à la structure de la couche de silicium décrite ci-dessus en référence à la figure 4, avec une première sous-couche 11 de type « N » et une seconde sous-couche 12 de type « P ».

La cellule photovoltaïque comporte une seconde couche 20 qui comprend des diamants fluorescents 30.

Cette seconde couche 20 est positionnée sur la première couche 10 en silicium et est une couche du côté extérieur de la cellule photovoltaïque 1 par rapport à la première couche 10 de telle sorte que des rayons lumineux sont aptes à illuminer ces diamants fluorescents 30.

Par couche « du côté extérieur » on entend une couche qui présente soit une surface libre en contact avec l'atmosphère, soit une surface recouverte d'une couche transparente à la lumière.

Dans les deux cas, cette surface est la face opposée de la face 21 en contact avec la première couche 10.

La seconde couche 20 comprend une matrice 29 dans laquelle sont noyés au moins partiellement des diamants fluorescents 30.

Ainsi, comme représenté sur la figure 1, une partie de chaque diamant 30 (ou de la majorité des diamants 30) dépasse de la matrice 29 et est ainsi apte à être illuminé par la lumière solaire. Avantageusement, la matrice 29 est transparente à la lumière solaire afin de permettre une illumination optimale des diamants 30.

Alternativement, les diamants 30 peuvent être noyés dans la matrice 29, qui est alors choisie transparente à la lumière solaire de telle sorte que la lumière solaire soit apte à illuminer les diamants 30.

Avantageusement, les diamants 30 couvrent une superficie qui est égale à au moins 30% de la superficie de la première couche 10.

En effet, l'efficacité de la cellule photovoltaïque 1 augmente avec une augmentation du pourcentage de la superficie de la première couche 10 qui est couvert par les diamants 30.

Encore plus avantageusement, les diamants 30 couvrent une superficie qui est égale à au moins 70% de la superficie de la première couche 10.

La matrice 29 est par exemple un composé d'oxyde de silice SiO₂ et d'oxyde de titane TiO₂.

La matrice 29 est par exemple un polymère.

Les diamants 30 sont fluorescents. En effet, un diamant est naturellement fluorescent, c'est-à-dire qu'il absorbe des photons et les réémet avec une longueur d'onde différente. Les diamants 30 fluorescents convertissent les photons de la lumière solaire en photons dont la longueur d'onde est plus grande, c'est-à-dire qui sont décalés vers le rouge et l'infrarouge. Or le rouge (650 à 700 nm) et l'infrarouge correspond à la partie du spectre lumineux dans laquelle la sensibilité lumineuse du silicium est maximale (figure 3). Les diamants 30 sont des diamants artificiels avec une fluorescence augmentée par rapport à la fluorescence d'un diamant naturel.

En effet, la fluorescence d'un diamant naturel est faible, et la détection de cette fluorescence requiert un détecteur plus sensible. L'utilisation de diamants 30 artificiels dont la fluorescence est supérieure à celle des diamants naturels permet de convertir un maximum de photons de la lumière solaire en photons dont la longueur d'onde est plus grande, c'est-à-dire qui sont décalés vers le rouge et l'infrarouge.

De tels diamants artificiels ont été mis au point et fabriqués par les inventeurs de la présente demande.

Ainsi, le rendement de conversion de la lumière solaire en lumière réémise est optimisé. Les diamants selon l'invention présentent en majorité des défauts constitués des couples {atome d'azote - lacune} (appelés centres NV pour « Nitrogen - Vacancy »). Ces couples sont formés d'un atome d'azote (qui est une impureté pour le diamant) et d'une lacune (absence d'atome, ici de carbone) dans le réseau cristallin du diamant.

En effet, les centres NV absorbent fortement dans le spectre visible et réémettent avec un haut rendement dans les longueurs d'onde de la couleur rouge et de l'infrarouge. Cette propriété est illustrée sur la figure 2, qui montre la courbe d'émission en fluorescence d'un centre NV pour une excitation à une longueur d'onde de 514 nm, avec en abscisse la longueur d'onde λ de la lumière et en ordonnée l'intensité de lumière I_{L} émise.

Ainsi, le rendement de conversion de la lumière solaire en lumière réémise est proche de son maximum égal à 1.

De plus, les diamants 30 présentent un indice de réfraction plus élevé que les autres matériaux, ce qui leur permet de diriger vers la première couche 10 même la lumière rasante (c'est-à-dire faisant un angle faible avec la surface de la seconde couche 20).

La seconde couche 20 peut par exemple être déposée par un procédé de type Sol-Gel inorganique. Ce procédé présente l'avantage de conduire à une seconde couche dans laquelle les diamants peuvent être aisément inclus.

Avantageusement, les diamants 30 sont des microdiamants.

On entend par microdiamant un diamant dont la dimension maximale est inférieure à 50 µm (1 µm = 1 micron = 10⁻⁶ m). On entend par « dimension maximale » la longueur du plus grand segment rectiligne joignant deux points quelconques d'un de ces diamants.

Ainsi, les diamants 30 peuvent être aisément incorporés dans la seconde couche 20.

Avantageusement, les diamants 30 ont chacun une dimension maximale qui est supérieure à 0,1 µm.

En effet, les diamants dont la dimension maximale est inférieure à 0,1 µm sont plus chers à produire, et certaines de leurs propriétés (telles que la dureté, l'indice de réfraction, la conductibilité thermique) sont dégradées par rapport à celles de diamants dont la dimension maximale est supérieure.

L'invention concerne également un panneau photovoltaïque comportant des cellules photovoltaïques selon l'invention.

## Revendications

1. Cellule photovoltaïque (1) comportant une première couche (10) qui est apte à générer une tension électrique lorsqu'elle est illuminée et qui est à base d'un matériau dont le spectre de sensibilité lumineuse est maximum entre 600 nm et 1300 nm, ladite cellule photovoltaïque (1) étant **caractérisée en ce qu'**elle comporte sur ladite première couche (10) une seconde couche (20) comprenant des diamants fluorescents (30), cette seconde couche (20) étant une couche du côté extérieur de ladite cellule photovoltaïque (1) de telle sorte que des rayons lumineux sont aptes à illuminer lesdits diamants fluorescents (30), **en ce que** lesdits diamants fluorescents (30) sont artificiels avec une fluorescence augmentée par rapport à la fluorescence d'un diamant naturel, et **en ce que** lesdits diamants fluorescents (30) présentent en majorité des défauts constitués des couples {atome d'azote - lacune}.

2. Cellule photovoltaïque (1) selon la revendication 1 **caractérisée en ce que** ledit matériau de la première couche (10) est du silicium.

3. Cellule photovoltaïque (1) selon l'une quelconque des revendications 1 ou 2 **caractérisée en ce que** ladite seconde couche (20) comprend une matrice (29) dans laquelle sont noyés au moins partiellement lesdits diamants fluorescents (30).

4. Cellule photovoltaïque (1) selon l'une quelconque des revendications 1 à 3 **caractérisée en ce que** lesdits diamants (30) couvrent une superficie qui est égale à au moins 30% de la superficie de ladite première couche 10.

5. Cellule photovoltaïque (1) selon l'une quelconque des revendications 1 à 4 **caractérisée en ce que** lesdits diamants (30) ont une dimension maximale comprise entre 0,1 µm et 50 µm.

6. Panneau photovoltaïque comportant des cellules photovoltaïques (1) selon l'une quelconque des revendications précédentes.

## Patentansprüche

1. Photovoltaikzelle (1), umfassend eine erste Schicht (10), die geeignet ist, eine elektrische Spannung zu erzeugen, wenn sie belichtet wird, und die auf einem Material basiert, dessen Lichtempfindlichkeitsspektrum zwischen 600 nm und 1300 nm maximal ist, wobei die Photovoltaikzelle (1) **dadurch gekennzeichnet ist, dass** sie auf der ersten Schicht (10) eine zweite Schicht (20) umfasst, die fluoreszierende Diamanten (30) umfasst, wobei diese zweite Schicht (20) eine Schicht auf der Außenseite der Photovoltaikzelle (1) ist, so dass die Lichtstrahlen geeignet sind, die fluoreszierenden Diamanten (30) zu belichten, dadurch, dass die fluoreszierenden Diamanten (30) künstlich sind mit einer erhöhten Fluoreszenz in Bezug auf die Fluoreszenz eines natürlichen Diamanten, und dadurch, dass die fluoreszierenden Diamanten (30) mehrheitlich Defekte aufweisen, die aus Paaren {Stickstoffatom - Lücke} bestehen.

2. Photovoltaikzelle (1) gemäß Anspruch 1, **dadurch gekennzeichnet, dass** das Material der ersten Schicht (10) Silicium ist.

3. Photovoltaikzelle (1) gemäß einem der Ansprüche 1 oder 2, **dadurch gekennzeichnet, dass** die zweite Schicht (20) eine Matrix (29) umfasst, in der die fluoreszierenden Diamanten (30) mindestens teilweise eingebettet sind.

4. Photovoltaikzelle (1) gemäß einem der Ansprüche 1 bis 3, **dadurch gekennzeichnet, dass** die Diamanten (30) eine Oberfläche bedecken, die gleich mindestens 30 % der Oberfläche der ersten Schicht (10) ist.

5. Photovoltaikzelle (1) gemäß einem der Ansprüche 1 bis 4, **dadurch gekennzeichnet, dass** die Diamanten (30) eine maximale Abmessung zwischen 0,1 µm und 50 µm aufweisen.

6. Photovoltaikplatte, umfassend Photovoltaikzellen (1) gemäß einem der vorhergehenden Ansprüche.

## Claims

1. A photovoltaic cell (1) including a first layer (10) that is able to generate electrical voltage when it is illuminated and that has a base of a material whose light sensitivity spectrum is maximum between 600 nm and 1300 nm, said photovoltaic cell (1) being **characterized in that** it includes, on said first layer (10), a second layer (20) comprising fluorescent diamonds (30), this second layer (20) being a layer on the outer side of said photovoltaic cell (1) such that light rays are able to illuminate said fluorescent diamonds (30), **in that** said fluorescent diamonds (30) are artificial with an enhanced fluorescence relative to the fluorescence of a natural diamond, and **in that** said fluorescent diamonds (30) have a majority of flaws made up of {nitrogen atom - hole} pairs.

2. The photovoltaic cell (1) according to claim 1, **characterized in that** said material of the first layer (10) is silicon.

3. The photovoltaic cell (1) according to any one of claims 1 or 2, **characterized in that** said second layer (20) comprises a matrix (29) in which said fluorescent diamonds (30) are at least partially embedded.

4. The photovoltaic cell (1) according to any one of claims 1 to 3, **characterized in that** said diamonds (30) cover a surface area that is equal to at least 30% of the surface area of said first layer (10).

5. The photovoltaic cell (1) according to any one of claims 1 to 4, **characterized in that** said diamonds (30) have a maximum dimension comprised between 0.1 µm and 50 µm.

6. A photovoltaic panel including photovoltaic cells (1) according to any one of the preceding claims.
